Europäisches Patentamt

European Patent Office

Office européen des brevets

(19)

(11) Numéro de publication: **0 157 682**
**A1**

## (12) DEMANDE DE BREVET EUROPEEN

(21) Numéro de dépôt: **85400489.2**

(22) Date de dépôt: **14.03.85**

(51) Int. Cl.⁴: **H 01 P 1/218,** H 03 D 9/06

(30) Priorité: **19.03.84 FR 8404200**

(43) Date de publication de la demande: **09.10.85**
**Bulletin 85/41**

(84) Etats contractants désignés: **AT BE CH DE FR GB IT LI NL SE**

(71) Demandeur: **ENERTEC, 12 Place des Etats Unis, F-92120 Montrouge (FR)**

(72) Inventeur: **Marcoux, Jean, 2 Allée Watteau, F-78180 Montigny Le Bretoneux (FR)**
Inventeur: **Barratt, Christopher, 20, rue d'Arceuil, F-75014 Paris (FR)**

(74) Mandataire: **Bentz, Jean-Paul, GIERS SCHLUMBERGER Service BREVETS 12, place des Etats-Unis, F-92124 Montrouge Cedex (FR)**

(54) **Filtre à résonance gyromagnétique et mélangeur combinés.**

(57) Le résonateur (Y) du filtre, ou l'un de ces résonateurs (Y3), est utilisé, avec ses boucles d'entrée (BE) et de sortie (BS), comme un transformateur à sortie équilibrée; ainsi la sortie du filtre, équilibrée, est constituée par les deux extrémités (B12, B34) de la boucle de sortie de ce résonateur, sur lesquelles le mélangeur est directement connecté.

0157682

## FILTRE A RESONANCE GYROMAGNETIQUE ET
## MELANGEUR COMBINES

La présente invention concerne un dispositif comportant un filtre à résonance gyromagnétique et un mélangeur, destiné à filtrer un premier signal hyperfréquence (RF) et à mélanger le signal hyperfréquence résultant du filtrage avec un second signal (OL), le filtre comprenant au moins un résonateur gyromagnétique placé dans un champ magnétique et opérant un couplage entre une boucle d'entrée recevant le premier signal hyperfréquence et une boucle de sortie.

Les filtres à résonance gyromagnétique sont bien connus dans le domaine des hyperfréquences. Ces filtres utilisent des résonateurs monocristallins, par exemple de ferrite GaYIG ou YIG (grenat yttrium-fer avec ou sans gallium), ou de ferrite de lithium, ou de baryum, placés dans le champ magnétique continu d'un électro-aimant; le réglage de l'intensité de ce champ magnétique permet de régler la fréquence de travail du filtre, qui ·fonctionne en passe-bande.

Un signal d'entrée hyperfréquence (RF), appliqué à l'une des extrémités d'une boucle d'entrée, dont l'autre extrémité est à la masse, excite le résonateur.

Le signal de sortie RF filtré est récupéré sur une boucle de sortie du filtre, analogue à la boucle d'entrée mais disposée dans un plan perpendiculaire à celui qui contient la boucle d'entrée.

Dans la plupart de leurs applications connues, les filtres à résonance gyromagnétique sont associées à des mélangeurs dont la fonction est de réaliser la modulation d'un premier signal d'entrée RF, constitué par un signal hyperfréquence filtré à analyser, au moyen d'un second signal hyperfréquence OL, constitué par un signal de référence provenant d'un oscillateur local, en vue de former un signal FI à fréquence intermédiaire.

Le signal de référence OL a une puissance constante sur toute une gamme de fréquences et la puissance du signal FI à fréquence intermédiaire donne une information sur la puissance du signal d'entrée RF.

Des mélangeurs associés à des filtres à résonance gyromagnétique peuvent en particulier être utilisés dans des analyseurs de spectres et plus généralement dans les récepteurs hyperfréquence à large bande.

Le problème de base que doivent résoudre les filtres à résonance gyromagnétique, en particulier lorsqu'ils sont associés à des mélangeurs, est double.

Il s'agit en effet d'une part d'isoler entre elles la voie RF d'entrée, la voie OL d'oscillateur local, et la voie FI de sortie sur laquelle se propage le signal de sortie à fréquence intermédiaire; en particulier, il s'agit de faire en sorte que l'impédance de sortie du filtre n'influe pas sur la voie OL et vice-versa.

Il s'agit d'autre part de chercher à supprimer les ondulations d'amplitude dans la réponse en fréquence de l'ensemble filtre-mélangeur, ces ondulations étant dues à la combinaison des désadaptations entre les impédances du filtre et du mélangeur, et d'une distance trop importante entre ce filtre et ce mélangeur.

Il est connu, dans l'art antérieur, de résoudre le problème d'isolement des voies RF, OL et FI en utilisant des transformateurs d'adaptation et de symétrisation dénommés "baluns" (de l'anglais : balanced-unbalanced transformers), montés à la sortie du filtre.

Compte tenu de leur encombrement, ces transformateurs sont physiquement disposés à l'extérieur du filtre, entre le filtre et le mélangeur par exemple, et sont responsables d'une augmentation considérable du trajet que doit parcourir le signal filtré pour atteindre le dispositif associé au filtre, le mélangeur par exemple.

Or, cette augmentation de trajet est responsable de la formation d'ondulations d'amplitude, telles que celles qui ont été mentionnées ci-dessus, apparaissant dans la réponse, en fonction de la fréquence, de l'ensemble filtre-mélangeur, et cumulant leurs effets néfastes aux pertes introduites par le balun.

Il est par ailleurs connu dans l'art antérieur de réduire les ondulations en intercalant un atténuateur entre le filtre et le dispositif associé, le mélangeur par exemple, ou en rapprochant au maximum ce filtre et ce dispositif associé (par exemple en intégrant ce dernier au filtre).

Néanmoins, d'une part les atténuateurs présentent l'inconvénient intrinsèque de réduire le niveau du signal d'entrée, et d'autre part il n'a pas été possible jusqu'à présent d'isoler l'une de l'autre les voies OL et FI en intégrant un mélangeur au filtre.

Dans ce contexte, la présente invention a pour but de proposer une combinaison d'un filtre à résonance gyromagnétique et d'un mélangeur permettant d'obtenir l'isolement des voies RF, OL et FI sans atténuation, et sans ondulations d'amplitude de la réponse en fréquence.

Le dispositif de l'invention comprenant un filtre et un mélangeur combinés se caractérise par le fait que la sortie du filtre est constituée par les deux extrémités de la boucle de sortie du résonateur gyromagnétique, et en ce que le mélangeur est directement connecté aux deux extrémités de cette boucle de sortie.

Pour garantir un bon isolement des voies et étendre au maximum la gamme dynamique de puissance du signal d'entrée RF, le mélangeur comprend de préférence quatre diodes dont deux relient à la masse les deux extrémités de la boucle de sortie du résonateur et dont les deux autres relient ces extrémités au conducteur d'arrivée du signal de référence.

Néanmoins le mélangeur pourrait par exemple ne comprendre que deux diodes reliant les extrémités de la boucle de sortie du résonateur au conducteur d'arrivée du signal de référence OL, ces extrémités étant par ailleurs reliées à la masse au moyen de deux résistances.

Le signal de fréquence intermédiaire résultant du mélange des premier et second signaux est prélevé sur l'une au moins des extrémités de ladite boucle de sortie au moyen d'une inductance.

Le mélangeur comprend avantageusement des voies d'amenée de la masse et du second signal (OL) qui sont réalisées sous forme d'un guide d'onde coplanaire. Pour des raisons de commodité de montage, ce guide d'onde est de préférence disposé dans un plan parallèle à la direction du champ magnétique auquel est soumis le résonateur, par exemple dans le même plan que la boucle de sortie de ce résonateur.

D'autres caractéristiques et avantages de l'invention ressortiront de la description qui en est faite ci-après, à

0157682

titre indicatif et nullement limitatif, en référence au dessin annexé, dans lequel :

- la figure 1 est un schéma de principe de la connexion d'un mélangeur à quatre diodes avec un transformateur d'isolement, représentant le principe mis en oeuvre dans l'invention;

- la figure 2 est une vue de face représentant le mode de connexion particulier, qui fait l'objet de la présente invention, entre le filtre et un dispositif associé, tel qu'un mélangeur;

- la figure 3 est une vue de dessus en perspective correspondant à la figure 2, dans le cas d'un filtre à trois résonateurs.

La présente invention concerne les filtres du type filtre YIG ou GaYIG, et les dispositifs qui leur sont associés, par exemple des mélangeurs.

Ces filtres comprennent, de façon connue, des résonateurs de ferrite $Y$, $Y_1$, $Y_2$, $Y_3$ soumis d'une part à un champ magnétique continu réglable H et d'autre part au rayonnement électromagnétique d'un signal d'entrée hyperfréquence RF circulant dans une boucle d'entrée BE, BE1, BE2, BE3, entourant au moins partiellement le résonateur et disposée dans un plan parallèle au champ magnétique H.

Pour chaque résonateur est prévue une boucle de sortie BS, BS1, BS2, BS3, analogue à la boucle d'entrée mais perpendiculaire à celle-ci.

Chaque résonateur induit dans la boucle de sortie qui lui est associée un signal de sortie RF se situant dans une bande dont la fréquence centrale est réglée par l'intensité du champ H et dont l'amplitude dépend de l'amplitude du spectre de fréquence du signal d'entrée RF dans cette bande.

Les résonateurs sont maintenus par des barreaux de matériau amagnétique (non représentés) dans l'entrefer EF d'un électro-aimant composé d'un pôle inférieur AI et d'un pôle supérieur AS. Le champ H est contrôlé en fonction du courant électrique alimentant cet électro-aimant.

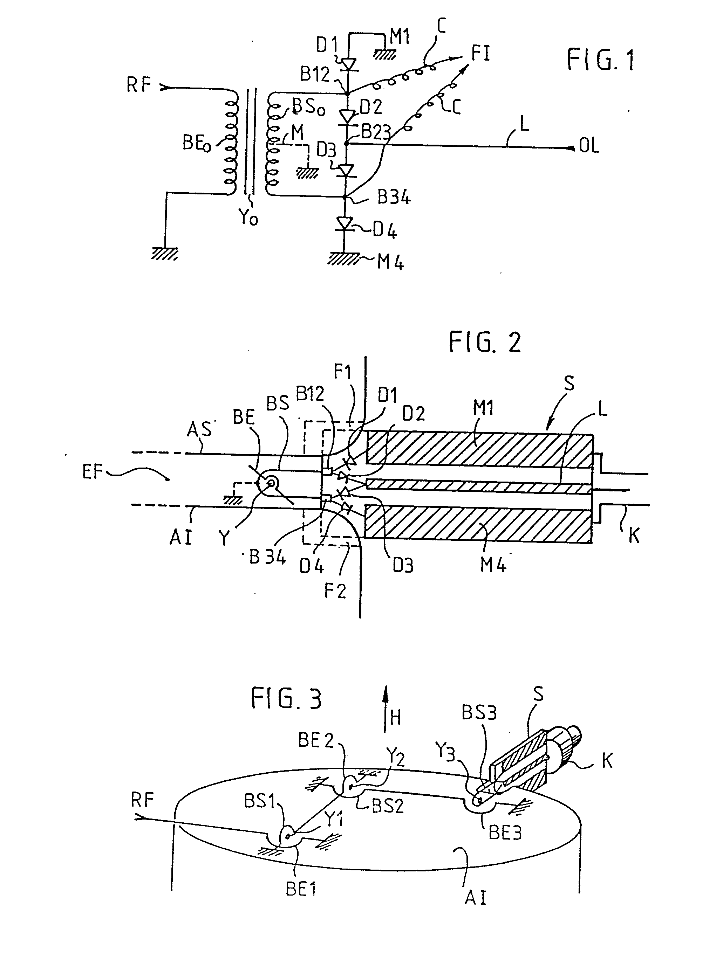

La figure 3 représente un filtre à trois résonateurs en cascade. Le signal de sortie des deux premiers résonateurs $Y_1$, $Y_2$ constitue le signal d'entrée des résonateurs respectifs suivants $Y_2$, $Y_3$.

Comme on le voit sur la figure 3, une extrémité de chaque boucle est reliée à la masse, c'est-à-dire que les signaux sont définis dans le filtre selon un mode asymétrique ou non équilibré, entre une polarité donnée et la masse.

La figure 1 est un schéma de connexion d'un filtre à résonance gyromagnétique tel qu'il vient d'être décrit avec un mélangeur à quatre diodes au moyen d'un transformateur "balun" selon le principe mis en oeuvre dans l'invention.

Il convient de noter que la figure 1 est un schéma basse-fréquence qui n'a pour but que de permettre une meilleure compréhension de l'invention; ce schéma, s'il était appliqué tel quel à un ensemble filtre-mélangeur basse fréquence, serait moins avantageux que les schémas traditionnels réalisant un double isolement des voies des signaux RF et OL.

Le signal d'entrée du transformateur est le signal RF de sortie du filtre.

Ce signal circule dans le primaire $BE_0$ du transformateur, relié à la masse. Ce transformateur comporte par ailleurs un noyau $Y_0$ et un secondaire $BS_0$; ce dernier, dont le point milieu M est physiquement ou virtuellement à la masse, est équilibré.

Au secondaire $BS_0$ est relié le mélangeur, composé d'une cascade de diodes $D_1$ à $D_4$, montées en série et dans le même sens, entre deux points de masse $M_1$, $M_4$.

Le signal de référence OL, à mélanger au signal RF, et par exemple issu d'un oscillateur hyperfréquence local, est amené par un conducteur L au point B23 intermédiaire entre les diodes $D_2$ et $D_3$.

Le secondaire du transformateur est connecté au mélangeur entre le point $B_{12}$ intermédiaire entre les diodes $D_1$ et $D_2$ et le point $B_{34}$ intermédiaire entre les diodes $D_3$ et $D_4$.

Le signal à fréquence intermédiaire FI dont la fréquence est la différence entre les fréquences du signal filtré RF et du signal de référence OL, est défini entre la masse et le point $B_{12}$ ou entre la masse et le point $B_{34}$, ou entre la masse et ces deux points, les points $B_{12}$ et $B_{34}$ étant sensiblement équipotentiels.

Le signal à fréquence intermédiaire FI peut être prélevé en $B_{12}$ et/ou $B_{34}$ au moyen d'un conducteur C torsadé ou bouclé formant une inductance permettant de filtrer les parasites induits par les signaux RF et OL.

Les figures 2 et 3 représentent notamment le mode réel de configuration équilibrée de sortie du filtre qui fait l'objet de la présente invention.

Cette configuration est obtenue en faisant jouer au résonateur gyromagnétique de sortie Y, $Y_3$ du filtre, et aux boucles d'entrée BE, BE3 et de sortie BS, BS3 qui lui sont associées, le rôle de transformateur d'isolement (balun). La boucle d'entrée joue le rôle du primaire, le résonateur le rôle du noyau, et la boucle de sortie le rôle du secondaire. Le point milieu de la boucle de sortie est physiquement ou virtuellement à la masse.

En conséquence, la sortie du filtre, qui se trouve ainsi définir un signal en mode symétrique ou équilibré, est directement constituée par les deux extrémités $B_{12}$ et $B_{34}$ de la boucle de sortie BS, BS3 du résonateur de sortie Y, $Y_3$, et le transformateur d'isolement fait ainsi partie intégrante du filtre.

Le mélangeur peut ainsi, lui-même, être directement monté à la sortie du filtre.

Cette solution permet d'une part de réduire au strict minimum la distance que doit parcourir le signal entre le filtre et le mélangeur et, en conséquence, les ondulations de la réponse en fréquence qui sont liées à la longueur de ligne entre ces organes, et, d'autre part de réaliser un très bon isolement de la voie d'entrée RF et de la voie de référence OL dans une bande de fréquence étroite se déplaçant avec la fréquence centrale de travail du filtre. Cette dernière caractéristique a pour conséquence que la plage d'adaptation du filtre et du mélangeur s'étend de façon homogène sur toute la plage de travail du filtre. Un tel avantage est d'autant plus significatif que les transformateurs d'isolement connus permettent très difficilement un isolement homogène satisfaisant sur une large bande.

Dans la description qui précède, et celle qui va suivre, le terme de "conducteur" est réservé à un élément de ligne identifié se distinguant par sa caractéristique physique de conduction, alors que le terme de "voie" est utilisé pour désigner un guide d'onde considéré du seul point de vue de sa fonction, quelle que soit la forme physique particulière qu'adopte ce guide d'onde.

La figure 2 reprend, avec les mêmes références, les éléments déjà visibles sur la figure 1.

La masse et le conducteur L d'amenée du signal de référence OL sont réalisés sous forme d'un guide d'onde coplanaire $M_1$, L, $M_4$ constitué par exemple de façon connue en soi par un dépôt métallique sur une face d'un support plat d'alumine S. Les diodes $D_I$ à $D_4$ utilisées sont par exemple, de façon également connue en soi, réalisées selon la technologie des connecteurs en ruban (beam lead).

La figure 2 correspond à un mode de réalisation permettant d'obtenir un bon isolement des voies RF et OL dans une gamme dynamique importante de puissance du signal RF d'entrée. Néanmoins les diodes $D_1$ et $D_4$ reliant la boucle de sortie BS, BS3 à la masse pourraient être remplacées par des impédances, par exemple des résistances.

Des fentes $F_1$, $F_2$ sont par exemple pratiquées dans les pôles AS et AI de l'électro-aimant en vue de recevoir le support S dont les bornes $B_{12}$ et $B_{34}$, disposées sur le bord antérieur de ce support et connectées à la boucle de sortie BS, doivent être aussi proches que possible du résonateur Y, $Y_3$.

Le support S et le guide d'onde $M_1$, L, $M_4$ qu'il porte

sont disposés dans un plan parallèle au champ magnétique H de l'électro-aimant, par exemple dans le plan de la boucle de sortie BS, BS3, de manière à simplifier le montage.

Un connecteur K pour ligne coaxiale, relié au guide d'onde coplanaire $M_1$, L, $M_4$, peut être rendu solidaire du bord postérieur du support K pour permettre l'amenée du signal de référence OL.

Les conducteurs torsadés ou bouclés C prélevant le signal FI résultant du mélange des signaux RF et OL n'ont pas été représentés sur les figures 2 et 3 pour des raisons de clarté du dessin. Il est clair néanmoins que ces conducteurs seraient reliés aux bornes $B_{12}$ et/ou $B_{34}$ de la boucle de sortie BS ou BS3.

Bien que les avantages de l'invention aient été essentiellement illustrés par la combinaison d'un filtre et d'un mélangeur, correspondant probablement au cas le plus courant d'application pratique de l'invention, et bien que la combinaison telle que décrite, d'un filtre et d'un mélangeur présente des avantages qui se cumulent avec les avantages propres d'un filtre à sortie équilibrée, il apparaîtra à l'homme de l'art que ce filtre à sortie équilibrée de l'invention, en raison notamment des pertes très faibles qu'il introduit par rapport à un ensemble filtre-balun, de sa plage d'adaptation homogène, et de son plus faible encombrement, possède un champ d'application très large et peut alimenter directement tout système de transmission à excitation symétrique.

- 11 -

0157682

## REVENDICATIONS

1. Dispositif, comportant un filtre à résonance gyromagnétique et un mélangeur, destiné à filtrer un premier signal hyperfréquence (RF) et à mélanger le signal hyperfréquence résultant du filtrage avec un second signal (OL), le filtre comprenant au moins un résonateur gyromagnétique placé dans un champ magnétique et opérant un couplage entre une boucle d'entrée recevant le premier signal hyperfréquence et une boucle de sortie, caractérisé en ce que la sortie du filtre est constituée par les deux extrémités de ladite boucle de sortie, et en ce que le mélangeur est directement connecté aux deux extrémités de ladite boucle de sortie.

2. Dispositif suivant la revendication 1, caractérisé en ce que le second signal est appliqué à chaque extrémité de ladite boucle de sortie à travers une diode.

3. Dispositif suivant la revendication 2, caractérisé en ce que chaque extrémité de ladite boucle de sortie est reliée à la masse par l'intermédiaire d'une diode.

4. Dispositif suivant la revendication 2, caractérisé en ce que chaque extrémité de ladite boucle de sortie est reliée à la masse par l'intermédiaire d'une résistance.

5. Dispositif suivant l'une quelconque des revendications 2 à 4, caractérisé en ce que le signal de fréquence intermédiaire résultant du mélange des premier et second signaux est prélevé sur l'une au moins des extrémités de ladite boucle de sortie au moyen d'une inductance.

6 Dispositif suivant l'une quelconque des revendications 2 à 5, caractérisé en ce que ledit mélangeur comprend des conducteurs d'amenée de la masse et du second signal qui sont réalisés sous forme d'un guide d'onde coplanaire.

7. Dispositif suivant la revendication 6, caractérisé en ce que ledit guide d'onde coplanaire est disposé dans un plan parallèle à la direction du champ magnétique auquel est soumis le résonateur.

FIG. 1

FIG. 2

FIG. 3

## Office européen des brevets

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | TELECOMMUNICATIONS AND RADIO ENGINEERING, vol. 35/36, no. 6, juin 1981, pages 72-76, Scripta Publishing Co., Silver Spring, US; V.P. GOLOLOBOV et al.: "Magnetically tuned semiconductor microwave devices" * Page 74, lignes 3-6 et figure 2 f; page 74, ligne 15 - page 75, dernière ligne et figure 3 * | 1,2,5 | H 01 P 1/218 H 03 D 9/06 |
| X | TELECOMMUNICATIONS AND RADIO ENGINEERING, vol. 32/33, no. 10, octobre 1978, pages 129-131, Scripta Publishing Co., Silver Spring, US; V.I. TSYMBAL et al.: "Use of ferrite resonators for selectively matching mirowave elements" * Page 130, dernier alinéa; figure 3 * | 1,2,4, 5 | |
| A | THE RADIO AND ELECTRONIC ENGINEER, vol. 48, no. 1/2, janvier/février 1978, pages 29-32, Institution of Electronic and Radio Engineers, New York, US; J. KÖHLER et al.: "Broadband microwave frequency doublers" * Figures 7,8 *  --- -/- | 6 | DOMAINES TECHNIQUES RECHERCHES (Int. Cl.4)  H 01 P H 03 D H 03 J |

Le présent rapport de recherche a été établi pour toutes les revendications

| Lieu de la recherche | Date d'achèvement de la recherche | Examinateur |
|---|---|---|
| LA HAYE | 19-06-1985 | LAUGEL R.M.L. |

0157682

Office européen
des brevets

RAPPORT DE RECHERCHE EUROPEENNE

Numéro de la demande

EP 85 40 0489

| DOCUMENTS CONSIDERES COMME PERTINENTS | | | Page 2 |
|---|---|---|---|
| **Catégorie** | Citation du document avec indication, en cas de besoin, des parties pertinentes | Revendication concernée | CLASSEMENT DE LA DEMANDE (Int. Cl.4) |
| A | FUNKSCHAU, vol. 52, no. 23, novembre 1980, pages 80-84, Munich, DE; M. ARNOLDT: "YIG-Komponenten, Prinzip, Aufbau und Einsatz" partie 1 ----- | | |
| | | | **DOMAINES TECHNIQUES RECHERCHES (Int. Cl.4)** |

Le présent rapport de recherche a été établi pour toutes les revendications

| Lieu de la recherche | Date d'achèvement de la recherche | Examinateur |
|---|---|---|
| LA HAYE | 19-06-1985 | LAUGEL R.M.L. |